# EUROPEAN PATENT APPLICATION

(11) **EP 4 697 050 A1**
(43) Date of publication of application: **18.02.2026**
(21) Application number: 24194732.4
(22) Date of filing: 15.08.2024
(51) Int. Cl.: G01R 33/38, G01R 33/3815

(54) **COOLING CONNECTOR FOR COOLING MULTIPLE MAGNET COILS BY A COLD HEAD**

(71) Applicant: Koninklijke Philips N.V., 5656 AG Eindhoven (NL)
(72) Inventor: VERNICKEL, Peter, Eindhoven (NL); LIPS, Oliver, Eindhoven (NL); FORTHMANN, Peter, 5656AG Eindhoven (NL)
(74) Representative: Philips Intellectual Property & Standards

(57) **Abstract**

The invention relates to a cooling connector (1) for cooling multiple magnet coils (2) by a cold head (3) of a cryostat (4) of a magnetic resonance examination apparatus (5), comprising
a first connector part (6), a second connector part (7) and a fastener (8), wherein
the first connector part (6) comprises a connecting surface (9) configured for physically connecting the first part (6) to the cold head (3) such that heat may be exchanged between the first connector part (6) and the cold head (3),
the second connector part (7) comprises connecting means (10) for physically connecting the second connector part (7) to cooling straps (11) of multiple magnet coils (2) such that heat may be exchanged between the second connector part (7) and the magnet coils (2) via the cooling straps (11),
the first connector part (6) and the second connector part (7) are designed in such a way that the first connector part (6) may be connected to the second connector part (7) via a receptacle-plug connection formed by the first connector part (6) and the second connector part (7), and
the connection between the first connector part (6) and the second connector part (7) via the receptacle-plug connection is secured by the fastener (8) which is configured for providing tight connection to the receptacle-plug such that heat may be exchanged between the first connector part (6) and the second connector part (7) via the receptacle-plug connection.

In this way, a cooling connector (1) for effectively cooling multiple magnet coils (2) by a cold head (3) of a cryostat (4) of a magnetic resonance examination apparatus (5) is provided, wherein the cooling connector (1) allows the magnet coils (2) to be attached to and separated from the cold head (3) in an easy and efficient way.

## Description

### FIELD OF THE INVENTION

The invention relates to magnetic resonance (MR) examination and especially, to a cooling system of a magnetic resonance imaging (MRI) apparatus.

### BACKGROUND OF THE INVENTION

In a magnetic resonance examination apparatus, the process of cooling the magnet's coils is crucial for maintaining the functionality and efficiency of the system. One prevalent method for cooling these coils involves using conduction-cooled technology, wherein copper cooling straps play a pivotal role. These straps serve as conduits, connecting the coil cooling terminals to a cold head, effectively dissipating the heat generated by the coils during operation. The design and installation of these cooling straps are not merely a matter of engineering convenience; they are helpful for ensuring optimal thermal performance of the MR system.

Conventional methods of making coil connections within the confined space of the cryostat present significant challenges for both assembly and maintenance.

In an ideal setup, all thermally conductive parts would be joined seamlessly through soldering or crimping, helpfully forming a single piece. This method reduces thermal resistance, ensuring optimal cooling efficiency. However, such an arrangement poses practical challenges during assembly and maintenance. Hence, there is a continuous effort for improving systems for facilitating easier handling, assembly, and repair processes.

### SUMMARY OF THE INVENTION

It is an object of the invention to provide a cooling connector for effectively cooling multiple magnet coils by a cold head of a cryostat of a magnetic resonance examination apparatus, wherein the cooling connector allows the magnet coils to be attached to and separated from the cold head in an easy and efficient way.

According to the invention, this object is addressed by the subject matter of the independent claims. Embodiments of the invention are described in the dependent claims.

Therefore, according to the invention, a cooling connector for cooling multiple magnet coils by a cold head of a cryostat of a magnetic resonance examination apparatus is provided, comprising
a first connector part, a second connector part and a fastener, wherein
the first connector part comprises a connecting surface configured for physically connecting the first part to the cold head such that heat may be exchanged between the first connector part and the cold head,
the second connector part comprises connecting means for physically connecting the second connector part to cooling straps of multiple magnet coils such that heat may be exchanged between the second connector part and the magnet coils via the cooling straps,
the first connector part and the second connector part are designed in such a way that the first connector part may be connected to the second connector part via a receptacle-plug connection formed by the first connector part and the second connector part, and
the connection between the first connector part and the second connector part via the receptacle-plug connection is secured by the fastener which is configured for drawing the receptacle-plug connection tight such that heat may be exchanged with low thermal resistance between the first connector part and the second connector part via the receptacle-plug connection.

The magnet of a superconducting MR system comprises multiple coils, each of which needs to be connected to the cooling mechanism. This results in a significant number of connections that must be meticulously managed within a confined space. The cryostat, the chamber housing these coils, is a limited and challenging environment to work within, further complicating the assembly and maintenance processes.

One of the primary challenges is the necessity to keep these connections as short as possible. Shorter connections are typically considered crucial for reducing thermal resistance and ensuring efficient heat transfer from the coils to the cold head. Any excessive length in these cooling straps can lead to suboptimal thermal performance, potentially affecting the overall functionality of the MR system. Therefore, the precision in the length and placement of these straps cannot be overstated.

However, the confined space within the cryostat imposes significant limitations on the ability to make these connections efficiently. The cryostat's design allows very little room to maneuver tools and hands, making it exceedingly difficult to reach the coil terminals and secure the cooling straps properly. This constraint not only complicates the initial assembly of the MR system but also poses considerable challenges for any subsequent maintenance or repair activities. The need to operate within such a tight space can lead to increased assembly times, potential errors in connection, and difficulty in ensuring that all connections are made to the highest standard of reliability.

Given these constraints, the ability to make the coil connections outside of the cryostat before final assembly presents a tremendous opportunity for simplification and efficiency. By pre-assembling the connections outside the cryostat, technicians can ensure that each connection is made precisely and securely without the spatial limitations imposed by the cryostat. This approach allows for more thorough inspections of each connection point, ensuring that they meet the required standards for thermal performance and durability.

Furthermore, pre-assembling these connections can significantly streamline the overall assembly process of the MR system. With the connections already in place, the final assembly within the cryostat can be performed more quickly and with greater ease, reducing the likelihood of errors and the need for rework. This approach not only enhances the initial assembly efficiency but also simplifies maintenance and repair tasks. When repairs are needed, technicians can address issues with greater speed and accuracy, knowing that the critical connections have been reliably made and tested outside the cryostat.

Conventional methods of making coil connections within the confined space of the cryostat presents significant challenges for both assembly and maintenance. The necessity to keep connections short for optimal thermal performance adds to the complexity. By enabling the pre-assembly of these connections outside the cryostat, this approach offers a practical solution that enhances the efficiency, reliability, and overall performance of the magnetic resonance examination apparatus, ensuring that the cooling mechanism operates at its highest potential. The magnet coils and the cooling straps can be conveniently assembled outside of the confined cryostat. Eventually, the magnet coil assembly gets slid into the cryostat and is connected to the cold head with little effort.

The feature that the first connector part comprises a connecting surface configured for physically connecting the first part to the cold head such that heat may be exchanged between the first connector part and the cold head, means that the connecting surface may be directly connected to the cold head but also allows for an indirect connection to the cold head, e.g., via cooling straps attached to the connecting surface and the cooling head.

One function of the cooling connector according to the invention is to facilitate heat exchange between the cold head and the magnet coils in a magnetic resonance examination apparatus. For example, the cold head is part of a two-stage cryo-cooling system. The first connector part has a connecting surface that allows it to physically connect to the cold head, enabling the transfer of heat to the cold head to the first connector part. The second connector part includes connecting means that allow it to connect to the cooling straps of multiple magnet coils, ensuring that heat can be transferred from the magnet coils to the second connector part via the cooling straps. The first and second connector parts are designed to form a receptacle-plug connection, allowing for easy and secure joining of the two connector parts and enabling efficient heat exchange between them. A fastener is used to secure this connection, drawing it tight to ensure a solid physical interface between the two parts, which is helpful for effective heat transfer. This design ensures efficient heat transfer from the magnet coils to the cold head, which is helpful for maintaining the functionality and efficiency of the MR system. By providing a secure and effective connection between the components, the cooling connector reduces thermal resistance and maximizes cooling efficiency.

The receptacle-plug connection allows for the coil connections to be pre-assembled outside the cryostat, simplifying the initial assembly process. Technicians can make and inspect connections without the spatial limitations imposed by the cryostat, which also simplifies maintenance and repair tasks, as the connectors can be easily disconnected and reconnected.

The modular design, featuring distinct first and second connector parts, allows for flexibility in assembly and disassembly. This modularity ensures that individual parts can be easily replaced or repaired without disturbing the entire system. The use of a fastener to secure the connection further enhances reliability, ensuring that the connection remains stable and effective over time.

By allowing for pre-assembly outside the cryostat, the design reduces the time required for final assembly within the cryostat, decreasing the likelihood of errors and rework, as technicians can work more comfortably and accurately outside the confined space. The cooling connector helps maintain the necessary low temperatures for the magnet coils, which is helpful for the system's long-term operation and stability.

In summary, the cooling connector according to the invention offers significant functional benefits and advantages by ensuring efficient heat transfer, simplifying assembly and maintenance processes, providing flexibility and reliability, reducing assembly time and errors, and enhancing the overall performance and durability of the MR system.

According to an embodiment of the invention, the first connector part and the second connector part are made from metal, for example copper. Copper, in particular, has excellent thermal conductivity. This means that it can efficiently transfer heat from the magnet coils to the cold head. By using copper for both connector parts, the cooling connector ensures that heat is rapidly and effectively moved away from the coils, which is helpful for maintaining the optimal temperature and performance of the MR system.

Further, according to an embodiment of the invention, one connector part is equipped with a wedge-shaped plug and the other connector part is equipped with wedge-shaped receptacle corresponding to the wedge-shaped plug such that the wedge-shaped plug and the wedge-shaped receptacle may be brought into a press connection via the fastener. The wedge shape allows for a very tight and secure fit between the plug and receptacle when they are brought together. This tight fit is helpful for efficient heat transfer, as it ensures maximum contact area between the two parts, reducing thermal resistance and allowing heat to move effectively from the magnet coils to the cold head.

The use of a fastener to press the wedge-shaped plug into the receptacle further secures the connection. This press connection ensures that the two parts remain firmly connected, even under the physical stresses and vibrations that may occur during the operation of the MR system. The stability provided by this connection reduces the risk of the parts loosening over time, which would otherwise degrade the thermal performance and reliability of the cooling system. Additionally, the wedge-shaped design simplifies the assembly and disassembly processes. The shape naturally guides the plug into the receptacle, making it easier to align and connect the parts correctly. This ease of alignment reduces the likelihood of errors during assembly, ensuring that the connections are made correctly and efficiently. It also facilitates maintenance and repairs, as the parts can be quickly and easily disconnected and reconnected when necessary. The press connection formed by the wedge-shaped plug and receptacle also helps to distribute the mechanical load evenly across the connection. This distribution reduces stress concentrations that could lead to material fatigue or failure, enhancing the durability and lifespan of the cooling connector.

In this respect, according to an embodiment of the invention, the connector part with the wedge-shaped plug has a wedge-shaped base body with opposing flat sloping side surfaces, the distance between which varies evenly along the middle axis between the opposing flat sloping side surfaces. This design enhances the functionality of the cooling connector by ensuring a tight and secure fit between the plug and the corresponding wedge-shaped receptacle. The varying distance between the flat sloping side surfaces means that, as the plug is inserted into the receptacle, the connection becomes progressively tighter. This tapering effect allows for a more controlled and stable insertion process, ensuring that the plug fits snugly into the receptacle.

The opposing flat sloping side surfaces of the wedge-shaped base body maximize the contact area between the plug and the receptacle. This increased contact area is helpful for effective heat transfer, as it reduces thermal resistance and allows heat to be transferred efficiently from the magnet coils to the cold head. The evenly varying distance between the side surfaces also helps to distribute mechanical loads evenly across the connection. This even distribution reduces stress concentrations that could lead to material fatigue or failure, enhancing the durability and longevity of the cooling connector.

Additionally, the flat sloping side surfaces provide a self-aligning feature during the assembly process. As the plug is inserted into the receptacle, the tapered shape naturally guides the plug into the correct position, making it easier to achieve a precise and secure connection. This self-aligning feature reduces the likelihood of misalignment and errors during assembly, ensuring that the connection is made correctly and efficiently. The secure fit achieved by the wedge-shaped plug and receptacle also enhances the stability of the connection. Once the fastener secures the press connection, the tapered design ensures that the parts remain firmly in place, even under the operational stresses and vibrations of the MR system. This stability is helpful for maintaining the reliability and effectiveness of the cooling system over time.

Instead of or additional to the wedge-shaped plug and receptacle, the plug and receptacle may have other complementary shapes, such as having rail-like features, permitting tight connection between their adjacent surfaces when brough together with the help of the fastener.

Therefore, in some of the embodiments the plug and receptacle are configured with complementary self-aligning features for bringing them into contact by means of the fastener.

Further, according to an embodiment of the invention, the fastener is connected to the first connector part and the second connector part in such a way that it does not only allow to draw the connector parts tight but also to disengage the second connector part from the first connector part. This dual functionality of the fastener enhances the cooling connector's performance and usability in several ways. Firstly, by allowing the fastener to draw the connector parts tight, it ensures a secure and stable connection. As mentioned above, this tight connection is helpful for efficient heat transfer between the magnet coils and the cold head, as it reduces thermal resistance and maximizes the contact area between the parts.

Moreover, the ability of the fastener to disengage the second connector part from the first connector part simplifies both assembly and maintenance processes. During assembly, the fastener can be used to quickly and securely connect the parts, ensuring that the connection is made correctly and efficiently. When maintenance or repairs are needed, the fastener can be easily operated to disengage the connector parts, allowing for quick and convenient access to the system components without the need for extensive disassembly. This ease of disengagement is particularly valuable in confined spaces like the cryostat, where maneuverability is limited. The ability to quickly disconnect and reconnect the parts reduces the time and effort required for maintenance tasks, reducing system downtime and ensuring that the MR system remains operational and efficient. Additionally, the design of the fastener to perform both tightening and disengaging functions enhances the overall reliability of the cooling connector. By ensuring that the connection can be both securely fastened and easily released, the fastener contributes to the durability and longevity of the system. It helps prevent wear and tear on the connector parts during assembly and disassembly, reducing the risk of damage and ensuring consistent performance over time.

In this respect, according to an embodiment of the invention, the fastener is a bolt or a threaded rod that goes through the first connector part and the second connector part. The use of a bolt or threaded rod ensures a strong and secure connection between the two connector parts. By threading the rod through both parts, it can be tightened to draw them closely together, ensuring that the connection is tight and stable. This tight connection is helpful for efficient heat transfer between the magnet coils and the cold head, as it maximizes the contact area and reduces thermal resistance.

The bolt or threaded rod design also allows for easy and precise adjustment of the connection. By simply turning the bolt or rod, the connector parts can be drawn tighter or loosened as needed. Further, connecting/disconnecting multiple straps is always possible with one fastener operation. This adjustability ensures that the connection can be fine-tuned to achieve the optimal tightness, enhancing the overall thermal performance of the system. Additionally, this type of fastener simplifies both assembly and maintenance processes. During assembly, the bolt or threaded rod can be quickly and securely inserted and tightened, ensuring a reliable connection with reduced effort. For maintenance or repairs, the same bolt or rod can be easily loosened to disengage the connector parts, allowing for quick access to the system components.

The use of a bolt or threaded rod also provides durability and reliability. These components are robust and capable of withstanding significant mechanical stress without deforming or breaking. This durability helps to ensure that the connection remains secure over time, even under the operational stresses and vibrations of the MR system. Moreover, the simplicity of the bolt or threaded rod mechanism makes it easy to use and maintain. It requires no special tools or complex procedures to operate, making it accessible for technicians during both assembly and maintenance tasks. This simplicity reduces the likelihood of errors and ensures that the connection can be made and released efficiently and effectively.

According to an embodiment of the invention, the second connector part is equipped with a loosener protrusion for disengaging the second connector part from the first connector part. The loosener protrusion provides a convenient means for separating the two connector parts. When it is necessary to disengage the second connector part from the first, the protrusion can be used to apply force in a specific direction, helping to release the tight connection created by the fastener. This makes the process of disconnecting the parts easier and more efficient, especially in confined or uncomfortable spaces where it might be difficult to apply force directly to the connector parts themselves.

The presence of a loosener protrusion simplifies maintenance and repair activities. When technicians need to access the system components, they can use the protrusion to quickly and safely disengage the connector parts. This reduces the time and effort required for disassembly, allowing for faster troubleshooting, repairs, or replacements of system components. The loosener protrusion also helps protect the integrity of the connector parts during disassembly. By providing a designated point to apply force, it reduces the risk of damage to the parts that could occur if force were applied inappropriately or unevenly. This protection helps maintain the durability and longevity of the connector parts, ensuring they can be reused reliably after maintenance. Additionally, the loosener protrusion enhances the overall user-friendliness of the cooling connector. Technicians can quickly identify and use the protrusion to disengage the connection, making the assembly and disassembly processes more intuitive and less prone to errors. This ease of use is particularly valuable in situations where rapid maintenance or repairs are necessary to reduce downtime of the MR system.

The connecting means of the second connector part for physically connecting cooling straps of the multiple magnet coils such that heat may be exchanged between the second connector part and the magnet coils via the cooling straps may, for example, be screw connections, bus bar connections, solder connections and/or crimp connections.

According to an embodiment of the invention, the connecting means comprises a rod which is configured for receiving cable lugs with a respective opening of the respective cable lug, wherein the rod is equipped with a screw connection for pressing the cable lugs on the rod together, either directly with direct contact between the cable lugs, or indirectly, e.g. via intermediate pieces arranged between the cable lugs on the rod. A helpful function of the rod with a screw connection is to securely hold and connect the cable lugs, which are attached to the cooling straps of the magnet coils. By arranging the cable lugs on the rod and then using the screw connection to press them tightly together, a secure and stable electrical and thermal connection may be established. This ensures that heat can be efficiently transferred from the magnet coils to the cooling connector, maintaining the optimal performance of the MR system. The screw connection provides a straightforward and reliable method for securing the cable lugs on the rod. By tightening the screw, the cable lugs are pressed firmly against each other and the rod, ensuring a tight and stable connection. This reduces the risk of loose connections, which could compromise the efficiency of heat transfer and the overall reliability of the cooling system.

This design also allows for easy assembly and disassembly. The cable lugs can be quickly arranged on the rod and secured by tightening the screw connection. During maintenance or repairs, the screw can be loosened to release the cable lugs, allowing for quick and convenient access to the cooling straps and other components. This ease of assembly and disassembly reduces maintenance time and effort, enhancing the overall efficiency of the system's upkeep. Additionally, the rod and screw connection design provides flexibility in managing multiple cable lugs. The rod can accommodate several cable lugs, making it possible to connect multiple cooling straps in an organized and efficient manner. This is particularly beneficial in the confined space of the cryostat, where managing multiple connections can be challenging. The use of a screw connection also ensures that the pressure applied to the cable lugs is evenly distributed. This even distribution helps maintain the integrity of the cable lugs and the rod, reducing wear and tear and prolonging the lifespan of the components.

The invention also relates to a cryostat with a cold head and multiple magnet coils, wherein the magnet coils are thermally connected to the cold head via a cooling connector as described above. A helpful function of this configuration is to ensure efficient cooling of the magnet coils within the cryostat. By using the cooling connector to thermally link the magnet coils to the cold head, heat generated by the coils during operation is effectively transferred to the cold head, where it can be dissipated. This efficient heat transfer is helpful for maintaining the optimal operating temperature of the magnet coils, ensuring the MR system functions reliably and accurately.

The use of the described cooling connector enhances the overall thermal performance of the cryostat. The connector's design, including features like the wedge-shaped plug and receptacle, the metal construction, and the screw connection for cable lugs, ensures that the thermal connection between the coils and the cold head is secure and stable. This reduces thermal resistance and maximizes the efficiency of heat transfer, which is helpful for the high-performance requirements of MR systems. Additionally, the cooling connector facilitates easier assembly and maintenance of the cryostat. The connector allows for pre-assembly of the thermal connections outside the confined space of the cryostat, simplifying the installation process. Technicians can connect the coils to the cold head more easily and accurately, reducing assembling time and the potential for errors. This ease of assembling also translates to simpler maintenance and repair tasks, as the connectors can be easily disengaged and reconnected when necessary.

The robustness and reliability of the cooling connector contribute to the durability and longevity of the cryostat. The secure and stable connections reduce the risk of thermal inefficiencies and mechanical failures over time. This reliability is helpful for maintaining the continuous and effective operation of the MR system. Furthermore, the modular nature of the cooling connector design allows for flexibility in the cryostat's configuration. Multiple magnet coils can be efficiently managed and connected to the cold head, accommodating various system designs and requirements. This flexibility ensures that the cryostat can be adapted to different MR system configurations and specifications.

In addition, the invention also relates to a cooling connector for cooling multiple magnet coils by a cold head of a cryostat of a magnetic resonance examination apparatus, with a connecting means which comprises a rod onto which cable lugs with a respective opening of the respective cable lug are arranged, wherein the rod is equipped with a screw connection for pressing the cable lugs on the rod together. A helpful function of this design is to create a secure and efficient thermal connection between the magnet coils and the cold head. The rod serves as a central point where multiple cable lugs, attached to cooling straps from the magnet coils, can be gathered and held in place. By using a screw connection, the cable lugs are pressed tightly together on the rod, ensuring a stable and reliable connection.

One of the key advantages of this design is the enhancement of thermal conductivity. When the cable lugs are pressed together tightly on the rod, it maximizes the contact area between them. This increased contact area reduces thermal resistance and ensures efficient heat transfer from the magnet coils to the cold head, maintaining the optimal temperature for the coils and ensuring the MR system operates effectively. The screw connection provides a straightforward and reliable method for securing the cable lugs. It allows for easy adjustment, enabling the technician to tighten the connection to the desired level of firmness. This ensures that the thermal connection remains stable and efficient over time, even under the operational stresses of the MR system.

Additionally, this design simplifies both the assembly and maintenance processes. During assembly, the cable lugs can be easily placed onto the rod and secured by tightening the screw connection. This reduces the time and effort needed for installation, making it more efficient. For maintenance or repairs, the screw can be loosened to release the cable lugs, allowing for quick and convenient access to the system components. This ease of disassembly and reassembly helps reduce downtime and simplifies the upkeep of the MR system. The rod and screw connection system also provides flexibility in managing multiple connections. It can accommodate several cable lugs in an organized manner, ensuring that the cooling straps from multiple coils are efficiently connected. This organization is particularly beneficial in the confined space of the cryostat, where managing numerous connections can be challenging.

Though this cooling connector with rod and screw connection, in general, can be combined with the cooling connector described further above, it should be emphasized that this embodiment may be used and applied independently of the cooling connector described further above.

The invention also relates to a cryostat with a cold head and multiple magnet coils, wherein the magnet coils are thermally connected to the cold head via a cooling connector with a rod and screw connection as described before.

According to an embodiment of the invention, the cooling straps are attached between the magnet coils and at least part of the cable lugs such that heat may be exchanged between the magnet coils and the respective cable lugs via the cooling straps. Further, according to an embodiment of the invention, cooling straps are attached between the cooling head and at least part of the cable lugs such that heat may be exchanged between the cooling head and the respective cable lugs via the cooling straps. The primary function of this configuration is to ensure efficient heat transfer throughout the system. The cooling straps attached between the magnet coils and the cable lugs transfer heat generated by the magnet coils to the cable lugs. Then, the cooling straps attached between the cable lugs and the cooling head transfer this heat away from the cable lugs to the cooling head, where it is dissipated. This two-step heat transfer process effectively maintains the optimal operating temperature of the magnet coils.

One key advantage of this design is the enhancement of thermal management. By using cooling straps to connect both the magnet coils to the cable lugs and the cable lugs to the cooling head, heat is efficiently transferred along a continuous path. This reduces thermal resistance at each connection point, maximizing the efficiency of the cooling process and ensuring the MR system operates reliably and effectively. Additionally, this design provides flexibility and reliability in thermal connections. The use of cooling straps allows for precise positioning and secure attachment, ensuring stable connections. This stability is helpful for maintaining consistent thermal performance over time. The dual connection setup is also advantageous for space usage within the cryostat. By strategically arranging the cooling straps between the magnet coils, cable lugs, and cooling head, the system can achieve efficient thermal paths while managing the confined space effectively. This is particularly important in the limited space of the cryostat, where efficient design is helpful for system performance and maintenance.

The materials used for the cooling straps, typically with high thermal conductivity like copper, ensure that the thermal connections are durable and effective. These materials can withstand the operational stresses of the MR system, reducing the risk of connection failure and reducing the need for frequent maintenance. The robustness of the cooling straps contributes to the overall reliability and longevity of the cooling system. Moreover, the use of cooling straps in this dual connection configuration simplifies assembly and maintenance processes. During assembly, the straps can be easily attached to their respective components, ensuring a quick and efficient setup. For maintenance or repairs, the straps can be disconnected and reconnected as needed, allowing for straightforward access to system components. This ease of handling reduces maintenance time and effort, enhancing the overall efficiency of the system's upkeep.

Further, operating the cryostat of a magnetic resonance examination apparatus at higher temperatures can significantly simplify the cryogenic structure of the magnet. When using materials such as MgB₂, which function well at these elevated temperatures, conduction cooling is a viable cooling method. This approach eliminates the need for complex helium pipe systems. Instead, one can use thermally conductive connections between the cold head and the magnet's coils. As mentioned above, these connections may be made using copper cooling straps with cable lugs at the ends, allowing for efficient thermal transfer.

According to an embodiment of the invention, over at least part of the length of the rod, cable lugs connected to a respective magnet coil and cable lugs connected to the cooling head, respectively, are arranged on the rod in alternating fashion. This design primarily functions to enhance the efficiency and effectiveness of heat transfer. By arranging the cable lugs in an alternating fashion, it ensures that the heat from the magnet coils is directly transferred to the cooling head through adjacent connections. This close proximity of connections allows for more efficient thermal conductivity and reduces the thermal resistance along the heat transfer path.

One advantage of this configuration is that it creates a more streamlined and organized thermal connection system. The alternating arrangement of the cable lugs ensures that each magnet coil's heat is promptly transferred to the adjacent cooling head connection, facilitating a smoother and more direct heat flow. This organization helps in maintaining a consistent temperature across the system, which is helpful for the reliable operation of the MR apparatus. Additionally, the alternating arrangement provides mechanical stability and balance along the rod. By distributing the cable lugs evenly, it prevents clustering and potential mechanical stress that could occur if all lugs from either the magnet coils or the cooling head were grouped together. This balanced distribution helps in maintaining the integrity of the rod and reduces the risk of wear and tear, enhancing the durability of the system.

According to an embodiment of the invention, the cable lugs are made from metal, e.g., from copper.

Further, according to an embodiment of the invention, the cooling straps are soldered to the cold head and the magnet coils, respectively. Soldering the cooling straps to the cold head and magnet coils ensures a highly secure and stable connection. Soldering creates a strong bond between the components, reducing the risk of the connections loosening over time. This stability is helpful for maintaining consistent thermal performance, as it ensures that the cooling straps remain firmly attached, facilitating efficient heat transfer. One of the key advantages of soldering is the enhanced thermal conductivity it provides. Soldered joints typically have lower thermal resistance compared to mechanical connections. This means that heat can be transferred more efficiently from the magnet coils to the cooling straps, and from the cooling straps to the cold head. The improved thermal conductivity helps in maintaining the optimal operating temperature of the magnet coils, ensuring the MR system functions effectively.

Soldering also helps in reducing thermal resistance at the connection points. The solder forms a continuous metal bridge between the cooling straps and the components they are connected to, ensuring that heat flows smoothly without significant resistance. This efficient heat transfer is helpful for the overall performance and longevity of the MR system. Additionally, soldering provides a reliable and durable connection that can withstand the operational stresses and vibrations of the MR system. The strong bond created by soldering is less likely to degrade or fail over time, reducing the need for frequent maintenance and ensuring long-term reliability. The use of soldering also simplifies the initial assembly process. Once the cooling straps are positioned correctly, soldering them in place ensures that they remain securely attached without the need for additional fasteners or clamps. This can streamline the assembly process, making it quicker and more efficient. Furthermore, soldered connections can provide better electrical continuity, which can be beneficial in systems where electrical grounding or shielding is important. The continuous metal connection created by soldering helps in maintaining consistent electrical and thermal properties, which can contribute to the overall stability and performance of the system.

The material of the rod for receiving the cable lugs may be made of a material with equal or higher thermal expansion coefficient than the material of the cable lugs. In this way, the force pressing the cable lugs together remains constant or increases while cooling the structure down.

It is possible two use several rods in parallel in a stack of cable lugs if preferred due to the size of the cable lugs. Further, several stacks of cable lugs may be provided if this is considered advantageous for performance and manufacturing.

Next to the cable lugs mechanical fixing parts may be integrated along the rod in order to fix the rod to a desired holder structure. Preferably, parts with low thermal conductivity are placed at the ends of the rod to avoid an interruption of the high thermal conductivity along the rod.

The invention also relates to a magnetic resonance examination apparatus with a cryostat as described before.

### BRIEF DESCRIPTION OF THE DRAWINGS

These and other aspects of the invention will be apparent from and elucidated with reference to the embodiments described hereinafter. Such an embodiment does not necessarily represent the full scope of the invention. In the drawings:
Fig. 1 schematically depicts a magnetic resonance examination apparatus according to an embodiment of the invention,
Fig. 2a schematically depicts a cooling connector according to an embodiment of the invention in a perspective view,
Fig 2b schematically depicts the cooling connector of Fig. 2a in a perspective view from below,
Fig. 3 schematically depicts another embodiment of a cooling connector,
Fig. 4 schematically depicts another embodiment of a cooling connector, and
Fig. 5 schematically depicts another embodiment of a cooling connector.

### DETAILED DESCRIPTION OF EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a method in a corresponding manner.

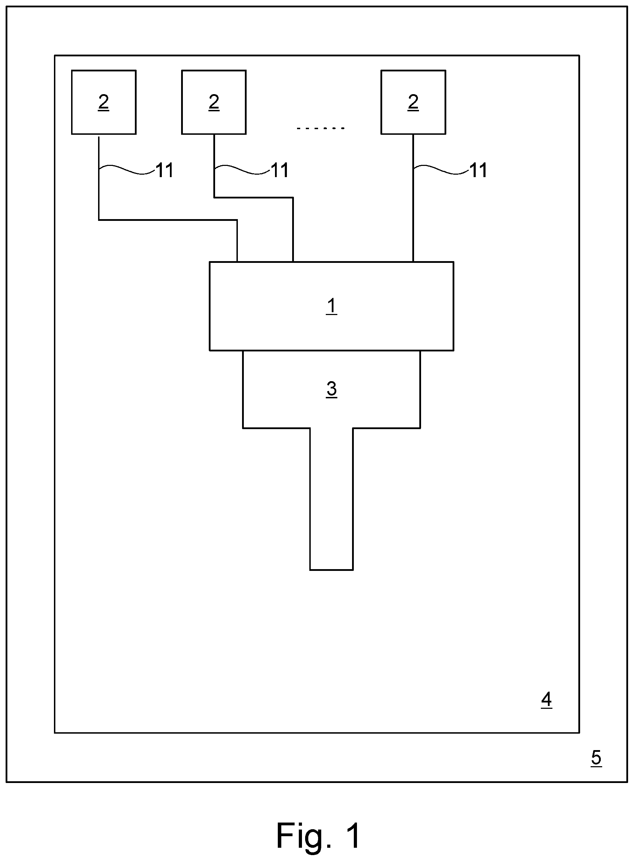

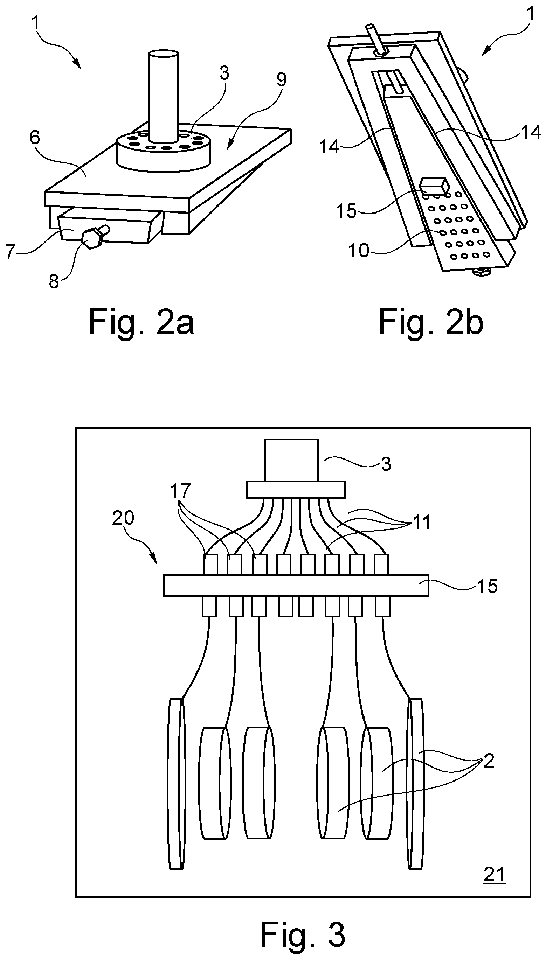

Fig. 1 schematically depicts a magnetic resonance examination apparatus 5 according to an embodiment of the invention, which comprises a cooling connector 1 for cooling multiple magnet coils 2 by a cold head 3 of a cryostat 4 of a magnetic resonance examination apparatus 5. As depicted in more detail in Figs. 2a and 2b, the cooling connector 1 comprises a first connector part 6, a second connector part 7 and a fastener 8. The first connector part 6 comprises a connecting surface 9 configured for physically connecting the first part 6 to the cold head 3 such that heat may be exchanged between the first connector part 6 and the cold head 3.

Here, the cold head 3 is directly attached to the flat connecting surface 9. The second connector part 7 comprises connecting means 10 for physically connecting the second connector part 7 to cooling straps 11 of multiple magnet coils 2 such that heat may be exchanged between the second connector part 7 and the magnet coils 2 via the cooling straps 11. Here, the connecting means 10 for physically connecting the second connector part 7 to the cooling straps 11 of the magnet coils 2 are screw holes, but they may also be configured as solder holes to which the cooling straps 11 can be directly soldered, or any recess configured for securing the colling straps to the second part. Alternatively or additionally, the connecting means may be in the form of protrusions to which the cooling straps can be secured, for example by means of end-lugs. It is important to note that the first connector part 6 and the second connector part 7 are designed in such a way that the first connector part 6 may be connected to the second connector part 7 via a receptacle-plug connection formed by the first connector part 6 and the second connector part 7. In this respect, the second connector part 7 is designed as a wedge-shaped plug and the first connector part 6 is designed as a wedge-shaped receptacle corresponding to the wedge-shaped plug such that the wedge-shaped plug and the wedge-shaped receptacle may be brought into a press connection via the fastener 8. The connection between the first connector part 6 and the second connector part 7 via the receptacle-plug connection is secured by the fastener 8 which is configured for drawing the receptacle-plug connection tight such that heat may be exchanged between the first connector part 6 and the second connector part 7 via the receptacle-plug connection. The wedge-shaped design allows for a tight and secure fit between the plug and receptacle, maximizing heat transfer efficiency by ensuring maximum contact surface between them and reducing thermal resistance. The use of a fastener 8 further secures the connection, maintaining stability even under operational stresses, which reduces the risk of parts loosening and degrading thermal performance. This design also simplifies assembly and maintenance, reduces errors, and distributes mechanical loads evenly, enhancing the overall reliability and durability of the MR system's cooling mechanism.

The connector part 7, which is designed as the wedge-shaped plug has a wedge-shaped base body with opposing flat sloping side surfaces 14, the distance between which varies evenly along the middle axis between the opposing flat sloping side surfaces 14. A wedge-shaped plug with a base body that has opposing flat sloping side surfaces 14 ensures a tight and secure fit, maximizes contact area for efficient heat transfer, distributes mechanical loads evenly, and provides a self-aligning feature that simplifies assembling.

Here, the fastener 8 is a threaded rod that goes through the first connector part 6 and the second connector part 7. In this way, the fastener 8 is connected to the first connector part 6 and the second connector part 7 in such a way that it does not only allow to draw the connector parts 6, 7 tight but also to disengage the second connector part 7 from the first connector part 6. In addition, the second connector part 7 is equipped with a loosener protrusion 15 for disengaging the second connector part 7 from the first connector part 6. The loosener protrusion 15 simplifies maintenance by allowing technicians to quickly and safely disengage the connector parts 6, 7, reducing the time and effort needed for disassembling. It protects the integrity of the connector parts 6, 7 by providing a designated point to apply force, reducing the risk of damage during disassembly. Additionally, it enhances user-friendliness, making the assembly and disassembly processes more intuitive and efficient, especially in situations requiring rapid maintenance or repairs.

Figs. 3 to 5 schematically depict alternative cooling connector 20 for cooling multiple magnet coils 2 by a cold head 3 of a cryostat 21 of a magnetic resonance examination apparatus 5, with a cooling connector 20 which comprises a rod 16 onto which cable lugs 17 with a respective opening of the respective cable lug 18 are arranged. The rod 16 is equipped with a screw connection 19 for pressing the cable lugs 17 on the rod 16 together. Here, cooling straps 11 are attached between the coils 2 and the cable lugs 17 such that heat may be exchanged between the magnet coils 2 and the respective cable lugs 17 via the cooling straps 11, and further cooling straps 11 are also attached between the cooling head 3 and the cable lugs 17 such that heat may also be exchanged between the cooling head 3 and the respective cable lugs 17 via the respective cooling straps 11.

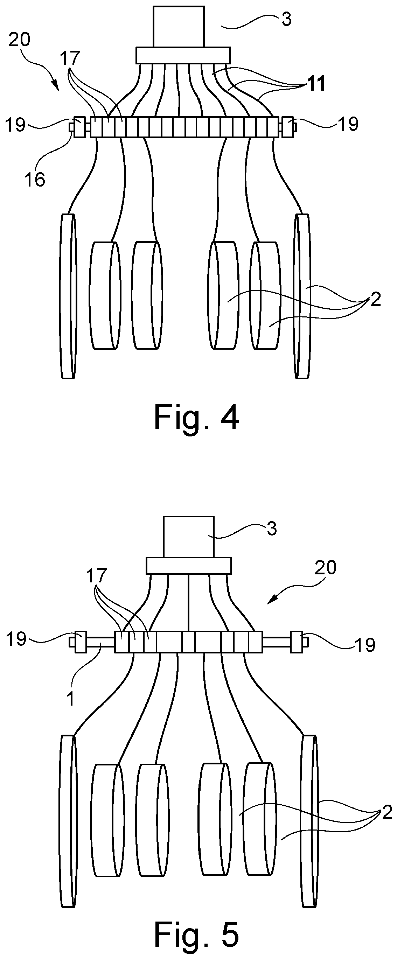

As depicted in Fig. 4, over the length of the rod 16, the cable lugs 17 connected to a respective magnet coil 2 and cable lugs 17 connected to the cooling head 3, respectively, are arranged on the rod 16 in alternating fashion. This design enhances heat transfer efficiency by arranging cable lugs 17 in an alternating fashion, ensuring direct and efficient thermal conductivity from the magnet coils 2 to the cooling head 3. The alternating arrangement streamlines the thermal connection system, maintaining consistent temperature and mechanical stability while reducing wear and tear on the rod 17. Additionally, it simplifies assembly and maintenance, reduces connection errors, and optimizes space utilization within the cryostat 21 for better airflow and thermal management.

The embodiment of Fig. 5 shows an arrangement with better cooling for the outer coils 2 where higher thermal load is expected and more modest cooling for the inner coils 2. In this respect, the cable lugs 17 of the outer coils are only in direct contact with cable lugs which are connected to the cold head 3, while cable lugs 17 of the inner coils 2 are also connected to cable lugs 17 of other inner coils 2.

It should be noted that the cooling straps 11 according to the embodiments shown in Figs. 3 to 5 are soldered to the cold head 3 and the magnet coils 2, respectively.

Further, it is important to note, that the embodiments of Figs. 1 and 2 and the embodiments of Figs. 3 to 5 may be combined but may also be used and applied fully independently from each other.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

## Claims

1. A cooling connector (1) for cooling multiple magnet coils (2) by a cold head (3) of a cryostat (4) of a magnetic resonance examination apparatus (5), comprising:
a first connector part (6), a second connector part (7) and a fastener (8), wherein
the first connector part (6) comprises a connecting surface (9) configured for physically connecting the first part (6) to the cold head (3) such that heat may be exchanged between the first connector part (6) and the cold head (3),
the second connector part (7) comprises connecting means (10) for physically connecting the second connector part (7) to cooling straps (11) of multiple magnet coils (2) such that heat may be exchanged between the second connector part (7) and the magnet coils (2) via the cooling straps (11),
the first connector part (6) and the second connector part (7) are designed in such a way that the first connector part (6) may be connected to the second connector part (7) via a receptacle-plug connection formed by the first connector part (6) and the second connector part (7), and
the connection between the first connector part (6) and the second connector part (7) via the receptacle-plug connection is secured by the fastener (8) which is configured for providing tight receptacle-plug connection such that heat may be exchanged between the first connector part (6) and the second connector part (7) via the receptacle-plug connection.

2. The cooling connector (1) according to claim 1, wherein one connector part (6, 7) of the first connector part (6) and the second connector part (7) is equipped with a wedge-shaped plug (12) and the other connector part (6, 7) is equipped with a wedge-shaped receptacle (13) corresponding to the wedge-shaped plug (12) such that the wedge-shaped plug (12) and the wedge-shaped receptacle (13) may be brought into a press connection via the fastener (8).

3. The cooling connector (1) according to claim 1 or 2, wherein the connector part (6, 7) with the wedge-shaped plug (12) has a wedge-shaped base body with opposing flat sloping side surfaces (14), the distance between which varies evenly along the middle axis between the opposing flat sloping side surfaces (14).

4. The cooling connector (1) according to any one of the previous claims, wherein the fastener (8) is connected to the first connector part (6) and the second connector part (7) in such a way that it does not only allow to draw the connector parts tight but also to disengage the second connector part (7) from the first connector part (6).

5. The cooling connector (1) according to any one of the previous claims, wherein the fastener (8) is a bolt or a threaded rod that goes through the first connector part (6) and the second connector part (7).

6. The cooling connector (1) according to any one of the previous claims, wherein the second connector part (7) is equipped with a loosener protrusion (15) for disengaging the second connector part (7) from the first connector part (6).

7. The cooling connector (1) according to claim 1, wherein the plug and receptacle are configured with complementary self-aligning features for bringing them into contact by means of the fastener.

8. The cooling connector (1) according to any one of the previous claims, wherein the connecting means (10) comprises a rod (16) which is configured for receiving cable lugs (17) with a respective opening of the respective cable lug (18), wherein the rod (16) is equipped with a screw connection (19) for pressing the cable lugs (17) on the rod (16) together.

9. A cooling connector (20) for cooling multiple magnet coils (2) by a cold head (3) of a cryostat (21) of a magnetic resonance examination apparatus (5), with a connecting means (10) which comprises a rod (16) onto which cable lugs (17) with a respective opening of the respective cable lug (18) are arranged, wherein the rod (16) is equipped with a screw connection (19) for pressing the cable lugs (17) on the rod (16) together.

10. A cryostat (21) with a cold head (3) and multiple magnet coils (2), wherein the magnet coils (2) are thermally connected to the cold head (3) via a cooling connector (20) according to any one of the previous claims.

11. The cryostat (21) according to claim 10 when depending on claim 8 or 9, wherein cooling straps (11) are attached between the coils (2) and at least part of the cable lugs (17) such that heat may be exchanged between the magnet coils (2) and the respective cable lugs (17) via the cooling straps (11).

12. The cryostat (21) according to claim 10 or 11, wherein cooling straps (11) are attached between the cooling head (3) and at least part of the cable lugs (17) such that heat may be exchanged between the cooling head (3) and the respective cable lugs (17) via the cooling straps (11).

13. The cryostat (21) according to claim 11 or 12, wherein over at least part of the length of the rod (16), cable lugs (17) connected to a respective magnet coil (2) and cable lugs (17) connected to the cooling head (3), respectively, are arranged on the rod (16) in alternating fashion.

14. The cryostat (21) according to any one of claims 10 to 13, wherein the cooling straps (11) are soldered to the cold head (3) and the magnet coils (2), respectively.

15. A magnetic resonance examination apparatus (5) with a cryostat according to any one of claims 10 to 14.
